# EUROPEAN PATENT SPECIFICATION

(11) **EP 2 297 376 B1**
(45) Date of publication and mention of the grant of the patent: **03.01.2018**
(21) Application number: 09769045.7
(22) Date of filing: 07.04.2009
(51) Int. Cl.: C23C 14/56

(54) **PROCESSING SYSTEM AND METHOD OF OPERATING A PROCESSING SYSTEM**
VERARBEITUNGSSYSTEM UND VERFAHREN FÜR DEN BETRIEB EINES VERARBEITUNGSSYSTEMS
SYSTÈME DE TRAITEMENT ET PROCÉDÉ POUR EXPLOITER UN SYSTÈME DE TRAITEMENT

(30) Priority: 27.06.2008 US 163498; 27.06.2008 EP 08159243
(43) Date of publication of application: 23.03.2011
(73) Proprietor: Applied Materials, Inc., Santa Clara, CA 95054 (US)
(72) Inventor: LINDENBERG, Ralph, 63654 Buedingen (DE); KOPARAL, Erkan, 61130 Nidderau (DE); BERGER, Thomas, 55585 Norheim (DE)
(74) Representative: Zimmermann & Partner Patentanwälte mbB
(86) International application number: PCT/EP2009/054149
(87) International publication number: WO 2009/156196

(56) References cited:
- EP-A- 1 801 843
- US-A- 5 741 405
- US-A- 5 858 863

## Description

### TECHNICAL FIELD

The present invention relates to a processing system for processing a substrate, comprising an arrangement of chambers including at least a first process chamber for processing the substrate, a second process chamber for processing the substrate, and/or a transfer chamber; at least a lock chamber configured for locking the substrate in the arrangement of chambers and/or locking a substrate out of the arrangement of chambers; a first substantially linear transport path for transporting the substrate from the lock chamber into the first process chamber, and a second transport path for transporting the substrate through the arrangement of chambers. The second transport path may be laterally offset relative to the first transport path and arranged adjacent to the first transport path.

### PRIOR ART

In a number of technical applications multiple layer stacks are deposited on a substrate in a sequence of coating steps. For example, in a TFT (Thin Film Transistor) metallization process two or three different metals are deposited by a sputtering process. Due to different coating rates in different process steps and due to different thickness of the layers the processing time in the coating stations for depositing different layers may vary considerably.

In order to deposit a multiple layer stack a number of configurations of coating and treatment chambers have been suggested. For example, in-line arrangements of coating chambers are used as well as cluster arrangements of coating chambers. A typical cluster arrangement comprises a central handling chamber and a number of coating chambers connected thereto. The coating chambers may be equipped to carry out the same or different coating processes. However, whereas in in-line systems the handling of the process is quite easy, the processing time is determined by the longest processing time. Therefore, the efficiency of the process is affected. Cluster tools, on the other hand, allow for different cycle times. However, the handling may be quite complex which requires an elaborate transfer system provided in the central handling chamber.

An alternative concept which combines in-line and cluster concepts has been described in document EP 1 801 843 A1. The document describes a coating system for depositing a TFT layer stack having a lock-in chamber, a metallization station for a first metallization process, a central handling chamber, two metallization stations for a second metallization process, and a second metallization station for the first process. The metallization chambers for the second process are arranged parallel to each other and used alternatively. The process chambers for the first metallization process are arranged in-line such that every substrate is processed in both chambers. The cycle time of the system is reduced by the combination of an in-line and a cluster concept as the combination minimizes handling complexity while increasing the throughput.

European patent application EP 07 002 828.7 (not published) refers to a transport means provided in a coating station having transport segments configured as combination segments which may alternately be positioned in a transport position. One of the segments may be moved in a treatment position while the other segment is moved in the transport position.

Furthermore, an in-line system has been proposed, wherein substrates are processed subsequently in different coating stations. In order to improve the throughput, at least some of the coating chambers include a processing position for a first substrate and a transport path laterally offset from the processing position, thereby leaving some space in the chamber for another substrate to pass or to overtake the first substrate. European patent application EP 1956 111 A refers to a transport means provided in a coating station having transport segments configured as combination segments.

Patent application US 12/163,498 (not published), discloses a coating system which has a first substantially linear transport path and a second substantially linear transport path, wherein the second transport path is laterally offset relative to the first transport path. Therefore, a first substrate may pass or overtake a second substrate on the first and second transport path, respectively.

However, all of the systems described above have some disadvantages. First, the systems require quite complex and expensive modules like e. g. rotational modules. Second, the throughout and efficiency of the systems is limited by their design.

Document US 5,741,405 discloses a sputter coating device which has two transport paths that are arranged parallel. Furthermore, a transfer chamber is provided.

### OBJECT OF THE INVENTION

It is an object of the present invention to increase the overall throughput and the efficiency of a coating system and to provide a method of processing a substrate which uses the components efficiently while avoiding the use of expensive and complex components.

### TECHNICAL SOLUTION

This object is solved by providing a processing system according to claim 1, and a method of operating a processing system according to claim 15. The dependent claims refer to preferred features of the invention.

A processing system for processing a substrate according to the present disclosure preferably comprises: an arrangement of chambers including at least a first process chamber for processing the substrate, a second process chamber for processing the substrate, and/or a transfer chamber; at least a lock chamber configured for locking the substrate in the arrangement of chambers and/or locking a substrate out of the arrangement of chambers; a first substantially linear transport path for transporting the substrate from the lock chamber into the first process chamber, and a second transport path for transporting the substrate through the arrangement of chambers. The second transport path may be laterally offset relative to the first transport path and arranged adjacent to the first transport path. At least one of the first process chamber, the second process chamber and the transfer chamber comprises means for transferring the substrate from the first transport path to the second transport path and/or from the second transport path to the first transport path. The means for transferring the substrate includes a combination of at least a first guidance section and a second guidance section, wherein the first guidance section is arranged parallel with the second guidance section.

The processing system is, for example, a coating system for depositing one or a plurality of layers on a substrate. The substrate may be transported through the system either without a carrier or attached to a carrier in order to be processed. The inventive coating system has two transport paths which are substantially linear. A linear transport path means an in-line path on which the substrate, the substrate carrier (particularly a substrate carrier having a substrate attached thereto) may be transported without a need to rotate the substrate/carrier in order to change the lateral position of the substrate/carrier or to displace the substrate/carrier laterally. On the other hand, the linear path may include deviations of the direction of the transport path from a straight line. The lock chamber, the first process chamber and the second process chamber may be arranged in-line with each other.

The first transport path and the second transport path may be arranged parallel. The first transport path and the second transport path extend from the inside of the lock chamber into the first process chamber. They may be substantially linear paths. It is a feature of the present invention that the first transport path and the second transport path are laterally offset. They do not intersect and they are not connected e.g. by a rotation module. The substrate may only be transported between the transport paths by means of a translational movement. In other words, the surface of the substrate which is to be coated is always adjusted to the same side of the in-line system. Consequently, the processing tools are arranged on the same side relative to the first transport path and the second transport path.

The first transport path and the second transport path form a dual path or a dual track. The dual track extends from the combined lock-in/lock-out chamber into the processing chambers, which may be, for example, a coating chamber for depositing a No layer of a TFT device.

The lock chamber is a combined lock-in and lock-out chamber. The lock chamber is a double track load/unload lock module. The substrates may be transported into the load lock from the arrangement of coating/process chambers as well as from a load station (e.g. swing station) for loading substrates to be coated. The load lock may be evacuated and vented, respectively. For example, before a substrate is transported into the load lock from the arrangement of coating/process chambers the lock-in/lock-out chamber is evacuated. Before a substrate is transported into the load lock from the load station for loading substrates the lock-in/lock-out chamber is vented. The same happens when a substrate is transported out the load lock chamber into the arrangement of coating/process chambers and the load station for loading substrates, respectively.

The lock-in/lock-out chamber/module may be a dual track module, a triple track module or a multi track module providing two, three or a plurality of positions for substrates received in the chamber. It may be a buffer chamber and/or a lock chamber which may be evacuated by means of a vacuum system.

At least one of the first process chamber, the second process chamber and the transfer chamber comprises means for transferring the substrate from the first transport path to the second transport path and/or from the second transport path to the first transport path. The means may comprise a roller drive, a gear drive, a hydraulic or pneumatic drive, etc. The transfer movement may be a vertical or a horizontal movement. It is a translational movement without any rotation of the substrate/carrier.

The means for transferring the substrate may include a transfer device for laterally displacing the substrate from the first transport path to the second transport path and/or from the second transport path to the first transport path. The transfer device may include e. g. a lifting device. The process chamber(s) and/or the lock chamber and/or the transfer chamber(s) may comprise a transfer device. In this way complex and expensive rotation modules may be dispensed with. The alignment of the substrate/carrier remains unchanged during the entire transport of the substrate/carrier from the combined lock-in/lock-out chamber through the system and back into the combined lock-in/lock-out chamber.

The means for transferring the substrate includes a transfer device for laterally displacing a section of the guidance from the first transport path to the second transport path and/or from the second transport path to the first transport path. This means that a section of the guidance is arranged either in the first transport path or in the second transport path to complete one of the first transport path and the second transport path. The section of the guidance may be a rail section which is laterally displaceable. The section is arranged in one of the chambers. The means for transferring the substrate is constructed to move a substrate, a substrate carrier, and/or a rail section from the first transport path to the second transport path.

It is preferred that the means for transferring the substrate includes a combination of at least a first guidance section and a second guidance section, wherein the first guidance section is arranged parallel with the second guidance section in a distance corresponding to the distance between the first transport path and the second transport path, and a transfer device for laterally displacing the combination for moving a substrate from the first transport path to the second transport path and vice versa. The combination may be configured as at least two parallel transport segments, one of which may be positioned in the first transport path or in the second transport path, and the other one in the second transport path, in the first transport path and in a third position, respectively. One of the rail segments may be moved in a position along the first transport path while the other segment may be moved in a position along the second transport path. The combination may be a dual track section with two track sections arranged parallel besides each other. In this embodiment of the invention the dual track section is laterally moveable, particularly transverse and/or in a direction perpendicular to the transport path.

In a preferred embodiment of the invention the arrangement of chambers comprises a second process chamber coupled in line with the first process chamber, wherein the first substantially linear transport path extends from the first process chamber into the second process chamber for transporting the substrate from the first process chamber into the second process chamber or from the second process chamber into the first process chamber, and the second substantially linear transport path extends from the first process chamber into the second process chamber for transporting the substrate from the second process chamber into the first process chamber or from the first process chamber into the second process chamber.

The first process chamber may be e.g. Mo coating station, the second process chamber may be e.g. an Al coating station. Between the first process chamber and the second process chamber there may be one or various other process chambers, buffer chambers, transfer chambers, etc. However, the first transport path and the second transport path both extend linearly through these intermediate chambers.

In a preferred embodiment of the invention the first substantially linear transport path extends from the second process chamber into the transfer chamber for transporting the substrate from the second process chamber into the transfer chamber or from the transfer chamber into the second process chamber, and the second substantially linear transport path extends from the transfer chamber into the second process chamber for transporting the substrate from the transfer chamber into the second process chamber or from the second process chamber into the transfer chamber. It is possible that in this configuration the transfer chamber is arranged between the first process chamber and the second process chamber, or coupled to the second process chamber on the side averted from the first process chamber.

It is preferred that the first substantially linear transport path extends from the first process chamber into the transfer chamber for transporting the substrate from the first process chamber into the transfer chamber or from the transfer chamber into the first process chamber, and the second substantially linear transport path extends from the transfer chamber into the first process chamber for transporting the substrate from the transfer chamber into the first process chamber or from the first process chamber into the transfer chamber. In this configuration the transfer chamber may be coupled to the first process chamber on a side averted from the lock chamber, and, if there is a second process chamber, arranged between the first process chamber and the second process chamber.

It is preferred that the means for transferring the substrate includes a third guidance section arranged parallel with the first guidance section and the second guidance section.

At least the lock chamber and/or the first process chamber comprises a first triple track module having at least three track sections arranged adjacent to each other, and wherein the triple track module is arranged laterally movable relative to the first transport path and the second transport path to move at least the second track section of the triple track module between at least a position aligned with the first transport path and a position aligned with the second transport path.

In other words, the first track section and the second track section of the triple track module may be aligned with the first transport path, and the first track section and the second track section of the triple track module may be aligned with the second transport path, and the third track section of the triple track module may be aligned with at least one of the first transport path and the second transport path.

Providing a third track section which may be laterally moved together with the first track section and the second track section facilitates a simultaneous and synchronized exchange of two substrates between two chambers. This is due to the fact that instead of a dual module having two track sections which allows a substrate to be laterally transferred from the first transport path to the second transport path and vice versa, the triple track module according to the invention makes sure that the lateral movement of the triple track module may be controlled to allow a simultaneous exchange of substrates between at least the in-line portion of the arrangement of chambers of the processing system, thereby increasing the efficiency of the system.

The triple track module arranged in a chamber of the processing system according to the invention is, at the same time, a transport module having a transport system for transporting a substrate along the first and second transport path, i.e. into the chamber, through the chamber, and out of the chamber. A first substrate (which is usually arranged in a substrate carrier while being transported through the arrangement of chambers) may be moved along the first transport path or the second transport path in the first, second or third track section, while a second substrate (which is also usually arranged in a substrate carrier while being transported through the arrangement of chambers) may be moved independently from the first substrate along another one of the first transport path and the second transport path in another one of the first, second and third track section.

It is preferred that the first track section is arranged laterally movable relative to the first transport path and the second transport path to move at least the first track section of the triple track module at least in a position aligned with the first transport path, and/or the third track section of the triple track module is arranged laterally movable relative to the first transport path and the second transport path to move the third track section of the triple track module in a position aligned with at least one of the first transport path and the second transport path.

Particularly, the lock chamber and the first process chamber may be arranged in line. One or both of the lock chamber and the first process chamber comprise a triple track module having three track sections.

The first transport path and the second transport path are arranged adjacent to each other, particularly parallel to each other, and extend through the arrangement of chambers according to the invention. In other words, a particular substrate may be transported from outside the arrangement of chambers through the arrangement of chambers either on the first transport path, on the second transport path, or on a route along portions of the first transport path and the second transport path.

The at least three track sections of the triple track module comprise three independently driven track sections. Therefore, a first substrate and a second substrate may be moved along the first transport path and the second transport path, respectively, within a particular chamber simultaneously. The triple track module may be moved in a way that each of the first track section and the second track section could be positioned in the first transport path and the second transport path, respectively. The third track section may be moved at least in the first transport path or the second transport path.

According to a system analysis in a conventional system having just two transport track sections arranged in a dual track module a simultaneous exchange is only possible between the first process chamber and the second process chamber in every second process cycle. It can be shown in a system analysis that when only providing a dual track layout in a dual path system the simultaneous exchange of substrates between two chambers is not always possible in a complete processing cycle.

It is preferred that the track sections of the first triple track module are configured to be driven independently in order to move two different substrates independently from each other along the first transport path or the second transport path. Therefore, it is possible to exchange substrates between two chambers arranged next to each other simultaneously. Each of the drives allows transporting a substrate in either a forward direction or a backward direction along the first transport path and/or along the second transport path.

In a preferred embodiment of the invention the lock chamber and the first process chamber each comprise a triple track module, namely the first triple track module and a second triple track module, respectively.

It is preferred that the arrangement of chambers comprises at least a second process chamber arranged in-line with the lock chamber and/or the first process chamber. Particularly, the second process chamber may be connected to the first process chamber, and the first process chamber may be connected to the lock chamber to form an in-line arrangement including the lock chamber, the first process chamber and the second process chamber. The arrangement of chambers may include at least a third process chamber coupled in line with the first process chamber and/or the second process chamber.

In a preferred embodiment of the invention, the second process chamber comprises a dual track module having at least two track sections which may be independently driven and which are arranged parallel to each other, and wherein the dual track module is arranged laterally movable relative to the first transport path and the second transport path, such that at least the second track section of the dual track module may be aligned with the first transport path and the second transport path.

Furthermore, the coating system may be connected to a feed module for feeding substrates into the arrangement of chambers and for receiving substrates from the arrangement of chambers. The feed module is connected to the lock chamber of the arrangement of chambers. The feed module may comprise a single track section which is laterally movable between the first transport path and the second transport path, or it may comprise a first track section fixedly arranged along the first transport path and a second track section fixedly arranged along the second transport path. The feed module may comprise a swing module.

It is preferred that the dual track module and/or the triple track module comprise two track sections and three track sections, respectively, fixedly arranged relative to each other. Fixedly arranged means that the respective track sections are always arranged at a certain distance from each other. This may be implemented by a suitable control of the movement of the track sections, a connection between the track sections, etc.

In another preferred embodiment of the invention the lateral distance between the two track sections of the dual track module and/or the lateral distance between the adjacent track sections of the triple track module corresponds to a lateral distance between the first transport path and the second transport path.

It is preferred that the first transport path and the second transport path are arranged parallel to each other and/or extend substantially linear through the arrangement of chambers. A linear arrangement means that the first transport path and the second transport path do not intersect. A substrate (carrier) may be transferred between the first transport path and the second transport path by laterally moving the dual track module or the triple track module.

In another preferred embodiment of the invention the first process chamber and/or the second process chamber comprise processing tools for processing a substrate positioned in a processing position. The processing of a substrate substantially includes depositing a coating layer on a surface of the substrate. Processing in different process chambers usually means depositing different coating layers on top of a substrate in order to form a layer stack on the surface of the substrate. Therefore, the process chambers may comprise coating tools provided on at least one side of the respective process chamber. The coating method may be any chemical vapor deposition (CVD) method, a physical vapor deposition (PVD) method, e.g. sputtering, an evaporation method, etc. Usually, the coating tools are arranged on a particular side of the in-line arrangement of chambers in order to provide a coating on one side of the substrate without having to turn the substrate around in the arrangement of chambers. The substrate moves along the first transport path and the second transport path with the first surface of the substrate facing a first side and the second surface of the substrate facing a second side relative to the first transport path and/or the second transport path.

It is preferred that the processing position of the substrate in the first process chamber and/or the second process chamber is arranged adjacent to the first transport path.

Particularly, the means for transferring the substrate includes a transfer device for laterally displacing the combination for moving a substrate from the first transport path to the second transport path and vice versa.

It is preferred that the first guidance section, the second guidance section and/or the third guidance section are arranged relative to each other in a distance corresponding to the distance between the first transport path and the second transport path.

The first process chamber, the second process chamber, and/or the transfer chamber may be coupled in line.

The processing system may comprise a transport system for transporting a substrate along the first transport path and along the second transport path. During the transport along the transport path the substrates may be supported in a substrate carrier. The substrates may be attached to the substrate carrier. In another embodiment the substrates may pass through the coating system without a carrier, e. g. by means of an air cushion transport system. The transport system is configured to transport the substrate and/or the substrate carrier along the transport paths, at least between the lock chamber, the first coating chamber, the second coating chamber, and/or the transfer chamber. The transport system may be integrated in the dual track module(s) and the triple track module(s), respectively. For example, the transport system comprises drive rollers arranged along a track section of the dual track module and the triple track module, respectively. The drive rollers (e.g. carrier drive rollers) are laterally movable relative to the first transport path and the second transport path. The substrates/ substrate carriers carrying the substrates are transported through the coating system sequentially.

The transport system may comprise at least a guidance for guiding a substrate along the first transport path and/or along the second transport path. The term substrate is used for substrate and/or for substrate carrier. The guidance may comprise a rail (usually arranged at the bottom and/or at the top of the chamber; provided that substrates are aligned vertically or at least inclined during the transport through the processing system). The guidance may comprise a magnetic guiding system which is usually arranged at the top of the vertically aligned substrate. However, any other transport system may be used in connection with the invention. Furthermore, the substrate may be transported in any alignment.

In a preferred embodiment of the invention the transport system comprises a first guidance for guiding the substrate along the first transport path and a second guidance for guiding the substrate along the second transport path.

In a preferred embodiment of the invention the first process chamber and/or the second process chamber include processing tools arranged in the respective process chamber laterally besides the first transport path. This arrangement is a consequence of the fact that a first surface of the substrate moving along the first transport path and the second transport path is always aligned in a direction towards the processing tools irrespective whether it moves along the first transport path or the second transport path. In this arrangement processing/coating tools are arranged at one side of the in-line arrangement, and only on this side. The substrate/carrier is never rotated when moving within the arrangement of chambers. Therefore it is not necessary to provide processing/coating tools on the other side of the in-line arrangement.

It is preferred that the track sections of the dual track modules and the triple track modules are configured to be driven independently in order to move two different substrates independently from each other along the first transport path or the second transport path.

In a preferred embodiment of the invention the lock chamber comprises a first triple track module, the first process chamber comprises a second a triple track module, and the second process chamber comprises a dual track module.

It is preferred that a combination of a first guidance section and a second guidance section form a dual track module, and the combination of a first guidance section, a second guidance section and a third guidance section form a triple track module.

The dual track module and/or the triple track module may comprise two track sections and three track sections, respectively, fixedly arranged relative to each other.

The track sections of the dual track module and/or the triple track module may be driven independently from each other to move a first substrate along the first transport path in a first direction and a second substrate along the second transport path in a second direction. The first direction and the second direction may correspond or be different.

According to the present disclosure, a method of operating a processing system as described above preferably comprises the steps of: a) transporting a first substrate from the lock chamber into the first process chamber along the first transport path, and depositing a first layer on the first substrate; b) laterally transferring the first substrate from the first transport path to the second transport path; and c) transporting the first substrate into the lock chamber along the second transport path, wherein the method comprises transporting a second substrate from the lock chamber into the first process chamber along the first transport path during the method step c).

A method for processing a substrate according to the invention comprises the steps of: a) Providing a coating system as described above; b) Depositing a first layer on a first substrate in the first process chamber; and c) Depositing a second layer on the substrate in the second process chamber. In a preferred embodiment of the invention the method comprises a further step d) depositing a third layer on the substrate in the first process chamber.

In a preferred embodiment of the invention the method comprises a further step d) depositing a third layer on the substrate in the first process chamber.

It is preferred that the substrates/carriers are transported sequentially into the lock chamber, the first process chamber, the second process chamber, the first process chamber and the lock chamber.

Particularly, during the process there are always at least three substrates arranged within the arrangement of chambers.

The first surface of the substrate is directed to the same side of the in-line arrangement during the complete process.

The method may include transferring the first substrate being processed at least once from the first transport path to the second transport path in order to enable a second substrate to pass the first substrate along the first transport path. The arrangement of chambers may include at least a transfer chamber for transferring the substrate from the first transport path to the second transport path and vice versa.

Another process in a configuration as described above may be outlined as follows. A first substrate is locked in the coating system via the lock-in/lock-out module. Afterwards the substrate is processed to receive a first layer, e.g. Mol layer, in the first process chamber. Then the substrate is transported into the second process chamber to obtain a second layer, e.g. an Al layer, before being transported back into the first chamber to obtain a third layer, e.g. a Mo2 layer, on top of the second layer. The second layer is much thicker than the first and the third layer. Therefore, the first chamber is used twice in processing one substrate while the second process chamber is used once during the process. After the Al coating process a second substrate coming from the first chamber passes the first substrate and obtains an Al layer in the second layer, and the first substrate obtains a Mo2 layer in the first chamber.

The method described above is sequentially repeated. The substrates pass the process stations sequentially.

The arrangement of chambers and the method are particularly advantageous for a process having a first layer requiring a short process time, and a second layer requiring quite a long process time. On the second layer a third layer requiring a short process time of the same material as the first coating layer may be deposited in the first process chamber.

It could be shown in a system analysis that a configuration and method as mentioned above provide for an optimized process and thus an excellent throughput and utilization of the chambers. Furthermore, in this configuration a large number of substrates can be transported through the arrangement of chambers concurrently. By using triple track modules as described, the number of process chambers may be reduced.

By means of the invention, a high throughput of the coating system may be achieved, while a complex construction and the inclusion of complex rotational modules may be avoided. Furthermore, the installation space needed for the arrangement of the coating system may be reduced.

A configuration as described having dual track modules and triple track modules may be applied to a plurality of different layouts of arrangements of process/handling modules. The features described above are claimed per se in any combination thereof.

### BRIEF DESCRIPTION OF THE DRAWING(S)

Further features and advantages of the invention will be apparent from the following description of preferred embodiments with reference to the appended drawings. The figures illustrate
- Figure 1: a first embodiment of a processing system according to the present invention;
- Figure 2: a second embodiment of a processing system according to the present invention;
- Figure 3: a third embodiment of a processing system according to the present invention in a first operational mode;
- Figure 4: the third embodiment of Fig. 3 in a second operational mode;
- Figure 5: a fourth embodiment of a processing system according to the present invention;
- Figure 6: a fifth embodiment of a processing system according to the present invention;
- Figure 7: a sixth embodiment of a processing system according to the present invention;
- Figure 8: a first embodiment of a coating system according to the present invention;
- Figure 9: the steps in a method of processing substrates in the system of figure 1; and
- Figure 10 a: sectional view of a triple track module according to the present invention.

### DETAILED DESCRIPTION OF PREFERRED EMBODIMENTS

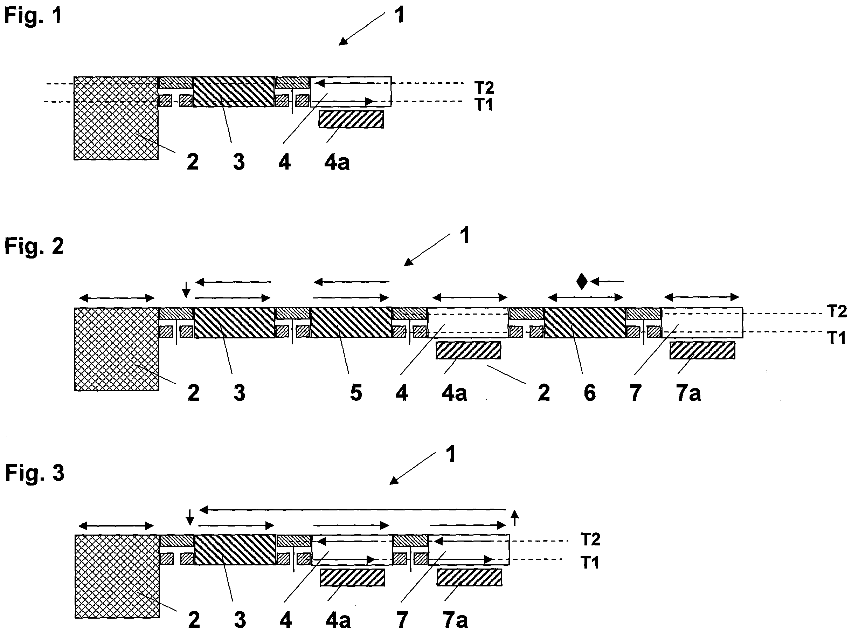

Figure 1 illustrates a first embodiment of a coating system 1 according to the present invention. The system 1 comprises a substrate feeding and receiving station (e. g. a swing station) 2 including a swing module which is operated in atmospheric pressure for feeding substrates into an arrangement of chambers and/or for receiving substrates processed in the coating system 1 from the arrangement of chambers.

The first embodiment of the invention corresponds to an arrangement of chambers which comprises a lock chamber 3 and a first coating chamber 4. The lock chamber 3 is configured as a combined lock-in/lock-out chamber. The first coating chamber 4 is equipped with coating tools 4a for depositing a layer on a substrate.

The arrangement of chambers consisting of the lock chamber 3 and the first coating chamber 4 has a first substantially linear transport path T1 indicated by dashed lines, and a second substantially linear transport path T2 indicated by dashed lines. The first transport path T1 and the second transport path T2 are arranged parallel without an intersection therebetween. The arrangement of the paths T1 and T2 establishes a dual track.

The system 1 includes a transport system for moving a substrate through the arrangement of chambers 3, 4 along the first transport path T1 and/or along the second transport path T2 as indicated by arrows. Particularly, a substrate is transported from the swing station 2 into the lock chamber 3 along the first path T1 and afterwards into the first coating chamber 4 along the first path T1. In this first position, the coating tools 4a are activated for depositing a material layer on the substrate. Afterwards, the substrate is transferred into a second position within first coating chamber 4 by means of a first displacement device (indicated by a doubleheaded arrow). The second position is located on the second transport path T2. Afterwards, the substrate is transported back into the lock chamber 3, transferred into a third position within the lock chamber 3 by means of a second displacement device (indicated by a doubleheaded arrow) and further into the swing station 2. The third position is located on the first transport path T1.

As soon as the substrate has been transferred into a position located along the second transport path T2, a second substrate may enter the arrangement of chambers 3, 4, and particularly the coating chamber 4 in order to be processed. This sequence may be repeated continuously, thereby providing a continuous flow of substrates through the system 1.

One or particularly both chambers 3 and 4 comprise transfer means for transferring the substrate/carrier from the first path T1 to the second path T2 by a lateral movement and/or from the second path T2 to the first path T1.

The transfer means may comprise an actuator which moves a single track section (e.g. rail section) provided in one of the chambers 3 or 4 between the first path T1 and the second path T2. Alternatively, the transfer means comprises a dual track section (dual rail section) configured as a combination of two track section being spaced apart to form a part of the first track T1 and the second track T2, respectively. The combination is laterally movable such that the track section corresponding to the first transport path T1 may be moved in a position along the second transport path T2. In another embodiment of the invention the transfer means may comprise a lift device for lifting the substrate from a position along the first transport path T1 laterally into a position along the second transport path T2. The invention is not meant to be limited to particular transfer means.

Figure 2 discloses a second embodiment of the present invention wherein the same reference numerals and symbols denote the same elements as described in connection with the first embodiment.

The system 1 according to the second embodiment comprises a buffer chamber 5 arranged between a lock chamber 3 and a first coating chamber 4. Furthermore, it comprises a transfer chamber 6 and a second coating chamber 7 having second coating tools 7a for depositing a second layer on a substrate. The transfer chamber 6 and the second coating chamber 7 form a linear arrangement of chambers together with the lock chamber 3, the buffer chamber 5 and the first coating chamber 4. It can been seen that both the first coating tools 4a and the second coating tools 7a are arranged on the same side of the in-line arrangement of the system 1 along the first transport path T1.

A method of operating the system 1 may include transporting a first substrate along the first transport path T1 from the lock chamber 3 into the buffer chamber 5 and into the first process chamber 4 wherein a first material layer is deposited on a first surface of the first substrate. Then the first substrate is transported into the transfer chamber 6 and into the second coating chamber 7. In the second coating chamber 7 a second material layer is deposited on top of the first material layer. Afterwards, the substrate is transported back into the transfer chamber 6. In the transfer chamber 6 the first substrate is transferred from a position on the first transport path T1 into a position on the second transport path T2 by transfer means as described above. This is indicated by double headed arrows in the transfer chamber 6. After this, a second substrate is received in the transfer chamber 6 from the first coating chamber 4 and transported into the second coating chamber 7 along the first transport path T1. Afterwards, the first substrate is transferred from the position along the second transport path T2 back into a position along the first transport path T1 and into the first coating chamber 4. In the first coating chamber 4 the first substrate receives a third material layer on top of the first material layer and the second material layer. Afterwards, the substrate is transported into the buffer chamber 5 wherein it is transferred into a position along the second transport path T2 in order to allow a third substrate to pass into the first coating chamber 4 along the first transport path T1. The first substrate leaves the processing system 1 via the lock chamber 3 along the second transport path T2. The sequence described in connection with a first, a second and a third substrate is repeated continuously to provide a sequential process.

Figure 3 illustrates a third embodiment of a coating system 1 according to the present invention. In an operational mode for depositing two layers on a substrate a first substrate is transported via the lock chamber 3 along the first transport path T1 into the first coating chamber 4. In the first coating chamber 4 a first layer is deposited on the surface of the first substrate. Afterwards, the first substrate is transported into the second coating chamber 7 for the deposition of a second layer on top of the first layer. Afterwards, the first substrate is transferred into a position along the second transport path T2 to generate space along the first transport path T1 for a second substrate to enter the second coating chamber 7. The first substrate is transported back via the first process chamber 4 and the lock chamber 3 along the second transport path T2. In the lock chamber 3 the first substrate is transferred from the position along the second transport path T2 into a position along the first transport path T1 to exit the arrangement of chambers to the swing station 2.

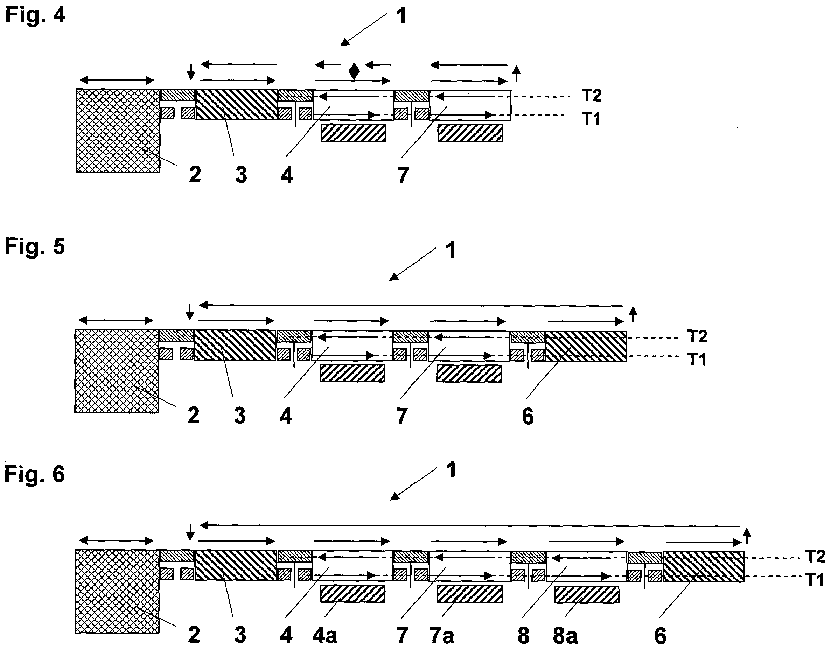

The same arrangement of chambers is disclosed in figure 4. However, in another operational mode three layers may be deposited on the surface of the substrate. A first substrate is transported via the lock chamber 3 into the first process chamber 4 for the deposition of a first coating layer on a first surface of the first substrate. Afterwards, the first substrate is transported into the second process chamber 7 for the deposition of a second layer on top of the first layer. Afterwards, the substrate is transferred into a position along the second transport path T2 for generating space for a second substrate to enter the second coating chamber 7 along the first transport path T1. Afterwards, the first substrate is transported back into the first coating chamber 4 and transferred therein from a position along the second transport path T2 into a position along the first transport path T1. In this position of the first substrate a third layer is deposited on top of the second layer. Afterwards, the first substrate is transferred back from the position along the first transport path T1 into a position along the second transport path T2 for generating space for a third substrate to enter the first coating chamber 4 along the first transport path T1. The first substrate is transported back into the lock chamber 3 and laterally displaced back to the first transport path T1 to exit the arrangement of chambers to the swing station 2. The second substrate, the third substrate, etc. follow the first substrate to generate a continuous flow of substrates through the system 1.

Compared with the third embodiment illustrated in figures 3 and 4 in a fourth embodiment of the invention is shown in figure 5. The system 1 comprises an additional transfer chamber 6 coupled to the second process chamber 7 to form an in-line arrangement of a lock chamber 3, a first process chamber 4, a second process chamber 7 and the transfer chamber 6.

In an operational mode where two layers are to be deposited on the surface of a substrate a first substrate is transported along the first transport path T1 to receive a first material layer and a second material layer in the first process chamber 4 and the second process chamber 7, respectively. Afterwards, the first substrate is transferred from the position along the first transport path T1 into a position along the second transport path T2 in the transfer chamber 6. A second substrate may follow the first substrate into the transfer chamber 6 along the first transport path T1. The first substrate is transported back into the lock chamber 3 along the second transport path T2 and then transferred in a position on the first transport path T1 to exit the system via the swing station 2.

Figure 6 illustrates an arrangement of chambers according to a fifth embodiment of a coating system 1 according to the present invention. In addition to the fourth embodiment, the coating system 1 includes a third process chamber 8 having third process tools 8a. The third process chamber 8 is arranged between the second process chamber 7 and the transfer chamber 6. Therefore, a substrate may pass through the system 1 along the first transport path T1 thereby receiving three material layers. In the transfer chamber 6 the substrate is transferred from the first transport path T1 to the second transport path T2 to travel back along the second transport path into the lock chamber 3, wherein it is transferred back to the first transport path T1 before exiting the system 1.

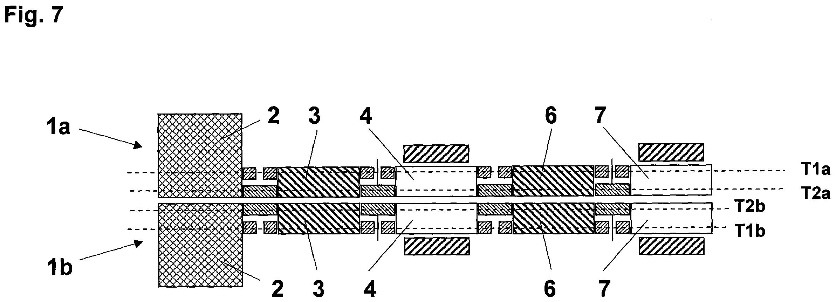

The system 1 according to figure 7 consists of two independent branches 1a and 1b, each of them having a first transport path T1a and a second transport path T2a and T2b, respectively.

Each branch comprises a swing station 2, a lock chamber 3, a first process chamber 4, a transfer chamber 6 and a second process chamber 7 arranged in-line. Each of the branches 1a, 1b is operated by a method for providing two layers or three layers on a substrate.

In the two-layer operational mode a first substrate is transferred from a position along the first transport path T1a, T1b in a position along the second transport path T2a, T2b after having received the first material layer and the second material layer. Then the first substrate is transported back along the second transport paths T2a and T2b, respectively, while a second substrate follows the first substrate on the first transport path T1.

In a three-layer operational mode a second substrate passes the first substrate in the transfer chamber 6. Afterwards, the first substrate is transferred back onto the first transport path T1a, T1b and into the first coating chamber 4 for the deposition of a third material layer on top of the second material layer. Afterwards, the substrate may be transferred onto the second transport path T2a, T2b within the first coating chamber 4 for exiting the system 1 via the lock chamber 3 and the swing station 2. In the meantime, a third substrate may pass into the first process chamber 4 along the first transport path T1.

A typical application for depositing a layer stack on a substrate is (as an example only) includes depositing a first Mo layer of a thickness of 400 A on the substrate, depositing a second Al layer of a thickness of 3500 A on top of the first layer, and depositing a third Mo layer of a thickness of 700 A on top of the second layer. The third layer is deposited in either the first coating chamber 4 or in the third coating chamber 8.

Various other configurations of chambers may be realized without departing from the concept according to the invention which includes having at least two transport paths T1 and T2 extending through the complete in-line arrangement extending through at least a lock chamber 3 and a first process chamber 4. By means of such system configurations it is possible to provide different operational modes to increase the efficiency of a coating system 1. Another advantage of using the dual track system 1 is that the number of venting/evacuation steps may be reduced, thus increasing the time available for the evacuation process. This is due to the fact that the load/unload lock chambers 3 have to be vented and evacuated only once for loading a first substrate and unloading a second substrate.

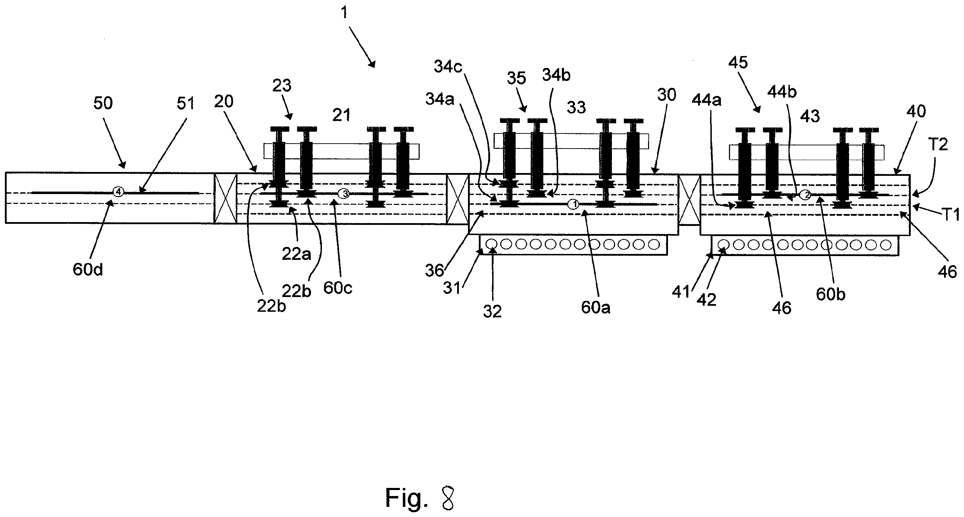

Figure 8 illustrates a coating system 1 according to an embodiment of the present invention. The coating system 1 comprises a lock chamber 20, a first process chamber 30 and a second process chamber 40. A swing module 50 is connected to the lock chamber 20 for feeding substrates 60a, 60b, 60c usually attached to substrate carriers into the coating system 1 and for receiving processed substrates 60a, 60b, 60c from the coating system 1 after a coating cycle.

The swing module 50, the lock chamber 20, the first process chamber 30 and the second process chamber 40 are configured as an in-line arrangement of modules. The arrangement comprises a first transport path T1 and a second transport path T2 which extend through the system and allow substrates to be transported through the system either on the first transport path T1, on the second transport path T2 or on a path including portions of both the first transport path T1 and the second transport path T2.

The lock chamber 20 comprises a triple track module 21 comprising a first track section 22a, a second track section 22b and a third track section 22c. The track sections 22a, 22b and 22c are connected with a transfer system 23 for laterally moving the track sections 22a, 22b and 22c. A lateral transfer of the track sections 22a, 22b and 22c allows positioning a substrate carrier being arranged in one of the track sections 22a, 22b or 22c to be either in a position along the first transport path T1 or in a position along the second transport path T2. In other words, at least one of the first track section 22a, the second track section 22b and the third track section 22c may be either aligned with the first transport path T1 or the second transport path T2. Particularly, at least the second track section 22b may be either aligned with the first transport path T1 or the second transport path T2.

The first process chamber 30 comprises a coating device 31 having coating tools 32, e. g. rotatable sputter cathodes. The coating device 31 of the process chamber 30 is arranged at the side of the first transport path T1.

Furthermore, the first process chamber 30 comprises a first triple track module 33 having a first track section 34a, a second track section 34b and a third track section 34c. The track sections 34a, 34b and 34c may be laterally transferred by means of a transfer system 35. At least the second track section 34b may be aligned with the first transport path T1 or the second transport path T2, and the third track section 34c may be aligned either the first transport path T1 or the second transport path T2. Each of the track sections 34a, 34b and 34c may also be positioned in a coating position 36, wherein a substrate 60a faces the coating device 31 and the coating tools 32 for depositing a coating layer on the substrate 60a.

The second process chamber 40 comprises a coating device 41 having coating tools 42, e. g. rotatable sputter cathodes. The coating layer deposited in the second process chamber 40 is different from the coating layer deposited in the first process chamber 30. Particularly, in the coating system 1 the process time for depositing a layer in the first process chamber 30 is much shorter than the process time for depositing a layer in the second process chamber 40. Therefore, the second coating tools 42 of the second coating chamber 40 are usually different from the first coating tools 32 of the first process chamber 30 in order to provide a different material layer on a substrate 60. The coating device 41 of the second process chamber 40 is arranged at the side of the first transport path T1.

The second process chamber 40 comprises a dual track module 43 having a first track section 44a and a second track section 44b. At least the second track section 44b may be aligned either with the first transport path T1, the second transport path T2, or be positioned in a coating position 46, wherein the substrate 60b faces the coating device 41. At least the first track section 44a may be positioned along the first transport path T1 or in the coating position 46.

The swing module 50 comprises a single track section 51 which is moveable between a position along the first transport path T1 and a position along the second transport path T2 in order to feed a substrate 60d into the coating system 1 or receive a substrate from the coating system 1.

It has to be emphasized that the invention is not delimited to this particular configuration of a lock chamber and process chambers, but may be implemented with in-line arrangements of lock chambers, buffer chambers, transfer chambers and a required number of process chambers.

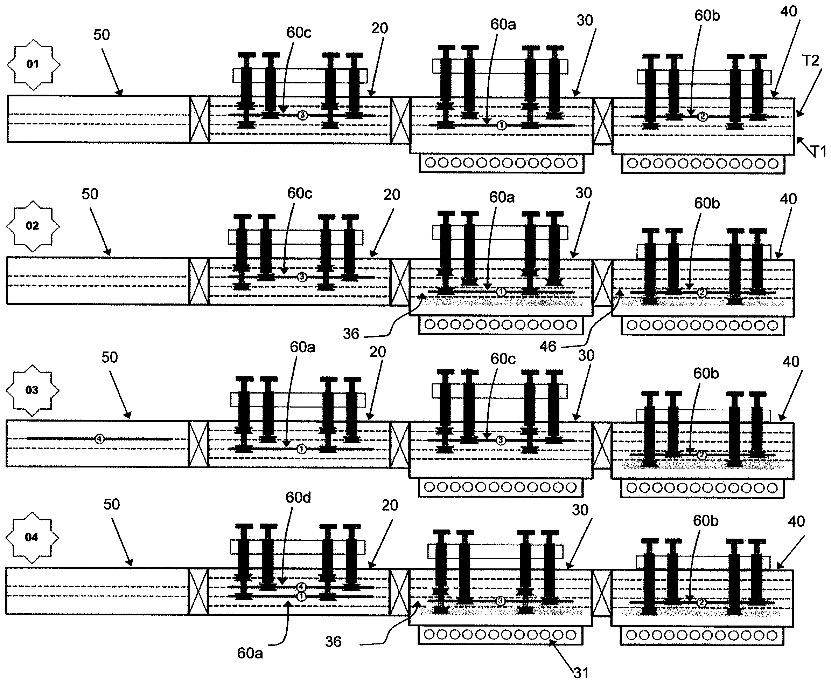

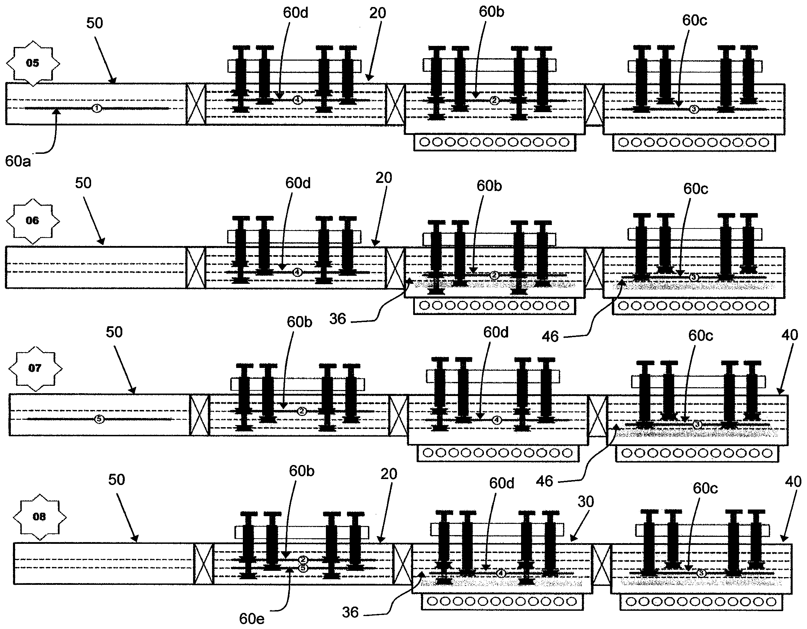

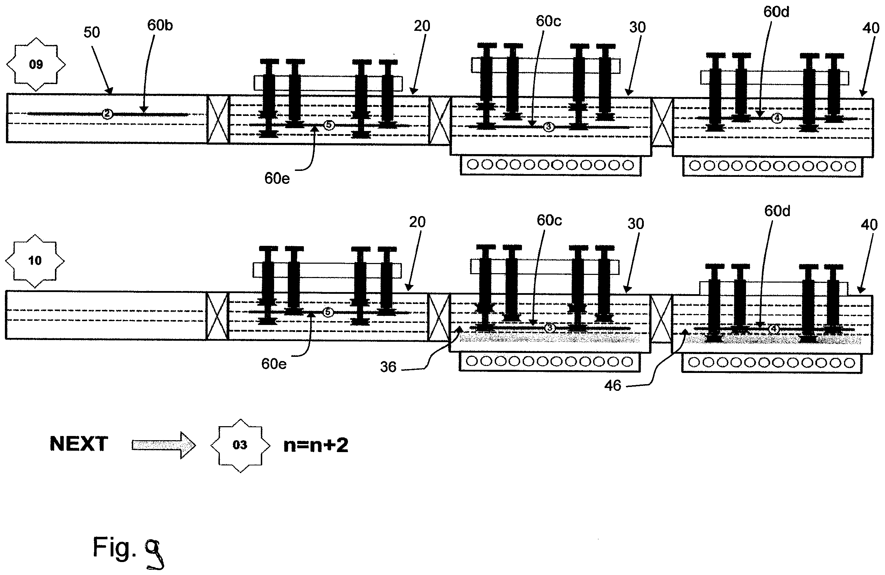

Figure 9 illustrates the steps in a method of processing a number of substrates 60a,.., 60e during a full coating cycle in a coating system 1 according to figure 8.

In a first process step 01 a first substrate 60a is arranged in the first process chamber 30 in the first track section 34a of the triple track module 33 of the first process chamber 30 in a position along the first transport path T1. A second substrate 60b is positioned in the second track section 44b of the dual track module 43 of the second process chamber 40 in a position along the second transport path T2. A third substrate 60c is arranged in the second track section 20b of the triple track module 21 of the lock chamber 20 in a position along the second transport path T2.

In a process step 02 the first substrate 60a is transferred into a coating position 36 for depositing a coating layer on the first substrate 60a. The coating layer is a third coating layer because the first substrate 60a has already been coated with a first coating layer and a second coating layer before. The second substrate 60b is also positioned in a coating position 46 in the second coating chamber 40 for depositing a layer on the second substrate 60b. The layer deposited on the second substrate 60b is a second layer because the second substrate 60b has already been coated with a first layer before. The third substrate 60c remains in the same position as in process step 01.

In a process step 03 the first substrate 60a has been retracted in a position along the first transport path T1 after finishing the coating process. Then it has been transported into a first track section 22a of the triple track module 21 of the lock chamber and the third substrate 60c has simultaneously been transported into a second track section 33b of the triple track module 33 of the first process chamber 30. In other words, the substrates 60a and 60c have changed the chambers simultaneously. The second substrate 60b is still being processed in the second process chamber 40.

In a process step 04, after the lock chamber 20 has been flooded, a fourth substrate 60d provided in the swing module 50 in process step 03 is transported into the lock chamber 20 into the second track section 22b of the triple track module of the lock chamber 20 in a position along the second transport path T2. The third substrate 60c has been transferred into a coating position 36 in the first process chamber 30 for depositing a first coating layer on the third substrate 60c. Therefore, the track sections of the triple track module 33 of the first process chamber 30 have been moved towards the coating device 31 until the second track section 34b is in to the coating position 36. The second substrate 60b is still being processed in the second process chamber 40.

In a process step 05 the first substrate 60a is removed from the coating system 1 to the swing module 50, while the fourth substrate 60d remains in the second track section 22b of the triple track module 21 of the lock chamber 20 in a position along the second transport path T2. The second substrate 60b, after the coating process in the second process chamber 40 had terminated, has been moved in a position along the second transport path T2 and transported into the first process chamber 30 onto the third track section 34c of the triple track module 33 of the first process chamber 30. Simultaneously the third substrate 60c has been transported from the second track section 34b of the triple track module 33 to the first track section 44a of the dual track module 43 along the first transport path T1. The substrates 60b and 60c have changed the chambers simultaneously.

In a process step 06 the second substrate 60b arranged in the third track section 34c of the triple track module 33 of the first process chamber 30 is transferred into the coating position 36 for depositing a third layer on the substrate 60b. Therefore, the track sections 34a, 34b and 34c of the triple track module 33 of the first process chamber 30 have been laterally moved towards the coating device 31. Furthermore, the third substrate 60c arranged in the first track section 44a of the dual track module 43 of the second process chamber 40 has been transferred into a coating position 46 by laterally moving the track sections 44a, 44b of the dual track module 43 of the second process chamber 40 for depositing a second coating layer on the third substrate 60c. The position of the fourth substrate 60d in the lock chamber 20 remains unchanged, while the lock chamber 20 is evacuated.

In a process step 07 the second substrate 60b has been removed from the coating position 36 in a position of the third track section 34c along the second transport path T2 and transported from the first process chamber 30 into the lock chamber 20. Simultaneously, the fourth substrate 60d has been transported from the second track section 22b of the triple track module 21 of the lock chamber into the second track section 34b of the triple track module 33 of the first process chamber 30. During the process step 07 the third substrate 60c is still in a coating position 46 in the second process chamber 40 for depositing the second coating layer on the substrate 60c.

In a process step 08, while the second substrate 60b remains in its position, a fifth substrate 60e provided in the swing module in process step 07 is transported onto the second track section 22b of the triple track module 21 of the lock chamber 20 along the first transport path T1. The fourth substrate 60d provided in the second track section 34b of the triple track module 33 of the first process chamber 30 is transferred into the coating position 36 for depositing a first coating layer on the fourth substrate 60d. In the second process chamber 40 the coating process for the third substrate 60c in the second process chamber 40 continues. In a process step 09 the second substrate 60b is removed from the coating system 1 into the swing module 50, whereas the fifth substrate 60e remains in its position along the first transport path T1 in the lock chamber 20. Furthermore, the fourth substrate 60d has been transferred into a position along the second transport path T2 in the first process chamber 30, and the third substrate 60c has been transferred in a position along the first transport path T1 in the second process chamber 40. Afterwards, the third substrate 60c has been transported onto the first track section 33a of the triple track module 33 of the first process chamber 30, and the fourth substrate 60d has been transported onto the second track 44b of the dual track module 43 of the second process chamber 40 simultaneously. In other words, the substrates 60c and 60d have exchanged between the first process chamber 30 and the second process chamber 40 concurrently.

In a process step 10 the fifth substrate 60e has been moved from a position along the first transport path T1 into a position along the second transport path T2 by a lateral movement of the triple track module 21 of the lock chamber 20. Furthermore, the third substrate 60c arranged in the first track section 34a of the triple track module 33 of the first process chamber 30 has been moved in the coating position 36 for depositing a third coating layer on the third substrate 60c. The fourth substrate 60d arranged on the second track section 44b of the dual track module 43 of the second process chamber 40 has been laterally moved into the coating position 46 for depositing a second layer on the fourth substrate 60d.

Process step 10 corresponds to a situation like in process step 02. Therefore, process step 11 corresponds to process step 03 with the number of the substrates being n+2 instead of n (e. g. substrate 3 instead of substrate 1). Due to the fact that there are always at least three substrates within the system and that at each point of time during the coating cycle a simultaneous exchange of substrates between the lock chamber 20, the first process chamber 30 and the second process chamber 40, respectively, is possible, the throughput of the system may be improved.

A system analysis shows that with dual track modules instead of triple track modules provided in the lock chamber 20 and in the first process chamber 30 there are situations in a coating cycle where handling time is lost due to the fact that no track section is available for a substrate to enter into a particular chamber.

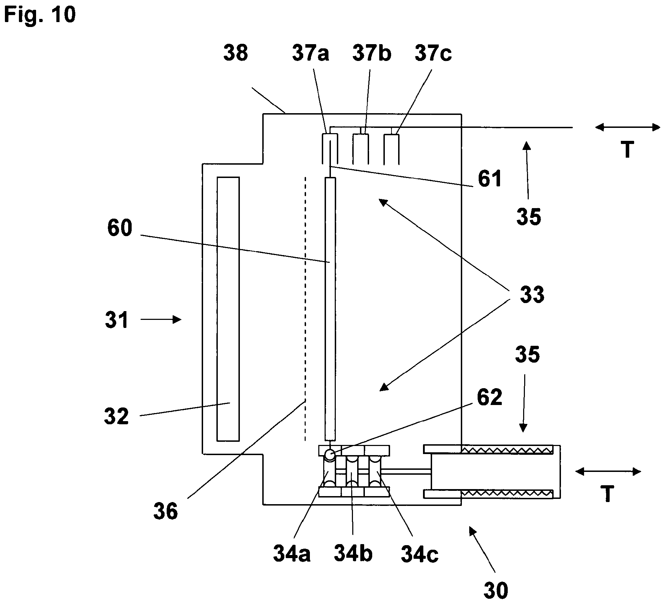

Including triple track modules where necessary in order to facilitate a simultaneous exchange of substrates between adjacent chambers at all times during a processing cycle for processing a plurality of substrates decreases the handling times and thus increases the throughput. Figure 10 illustrates a sectional view of a schematic design of a triple track module 33 provided in a process chamber 30.

The process chamber 30 comprises a vacuum chamber 38, and a coating device 31 having coating tools 32, e. g. rotational sputter cathodes.

A substrate 60 to be coated is arranged in a substrate carrier 61. The substrate carrier 61 comprises a bottom guide rail 62 which interacts with carrier drive rollers 34a, 34b and 34c of the triple track module 33. In the top region the carrier 61 interacts with magnetic guides 37a, 37b and 37c to keep the substrate 60 in an upright position.

The triple track module 33 comprises three tracks 34a / 37a, 34b / 37b and 34c / 37c for transporting a substrate through the coating chamber 30 along a first transport path T1 or a second transport path T2. The transport is facilitated by rotating carrier drive rollers 34a, 34b and 34c by means of a drive.

Furthermore the triple track module 33 may be moved laterally relative to the transport direction by actuation of a transfer system 35, indicated by arrows T. Therefore, the track sections 34a / 37a, 34b / 37b and 34c / 37c may be aligned with a first transport path T1 extending through a coating system and / or a second transport path T2 extending through the transport system (T1 and T2 being arranged perpendicular to the direction T). Furthermore, each of the track sections 34a / 37a, 34b / 37b and 34c / 37c may be moved in a coating position 36 for coating a substrate 60 arranged in the respective track section 34a / 37a, 34b / 37b and 34c / 37c, respectively, using the coating device 31.

A triple track module 31 as shown may be provided in one or a plurality of coating chambers in a dual track coating system, whenever it facilitates a simultaneous exchange of substrates between each couple of adjacent chambers at all times of a process cycle.

## Claims

1. A processing system (1) for processing a substrate, comprising:
an arrangement of chambers including
at least a first process chamber (4, 30) for processing said substrate, a second process chamber (7, 40) for processing said substrate, and/or a transfer chamber (6);
at least a lock chamber (3, 20) configured for locking said substrate in said arrangement of chambers and/or locking a substrate out of said arrangement of chambers;
a first transport path (T1) for transporting said substrate through said arrangement of chambers; and
a second transport path (T2) for transporting said substrate through said arrangement of chambers, wherein
said second transport path (T2) is laterally offset relative to said first transport path (T1), wherein
at least one of said first process chamber (4, 30), said second process chamber (7, 40) and said transfer chamber (6) comprises means for transferring said substrate from said first transport path (T1) to said second transport path (T2) and/or from said second transport path (T2) to said first transport path (T1), wherein
said means for transferring said substrate includes a combination of at least a first guidance section and a second guidance section, wherein said first guidance section is arranged parallel with said second guidance section in a distance corresponding to the distance between the first transport path and the second transport path, and wherein
said means for transferring said substrate comprises a transfer device for laterally displacing the combination for moving the substrate from the first transport path (T1) to the second transport path (T2) and vice versa.

2. The processing system (1) of claim 1, **characterized in that**
said means for transferring said substrate includes a third guidance section arranged parallel with said first guidance section and said second guidance section.

3. The processing system (1) of claim 1 or 2,
**characterized in that**
said means for transferring said substrate includes a transfer device for laterally displacing said combination for moving a substrate from said first transport path (T1) to said second transport path (T2) and vice versa.

4. The processing system (1) of any of the previous claims,
**characterized in that**
said first guidance section, said second guidance section and said third guidance section are arranged relative to each other in a distance corresponding to the distance between said first transport path (T1) and said second transport path (T2).

5. The processing system (1) of any of the previous claims,
**characterized in that**
said first process chamber (4, 30), said second process chamber (7, 40), and/or said transfer chamber (6) are coupled in line.

6. The processing system (1) of any of the previous claims,
**characterized in that**
said processing system (1) comprises a transport system for transporting a substrate along said first transport path (T1) and along said second transport path (T2).

7. The processing system (1) of claim 6,
**characterized in that**
said transport system comprises at least a guidance for guiding a substrate along said first transport path (T1) and/or along said second transport path (T2).

8. The processing system (1) of claim 7,
**characterized in that**
said transport system comprises a first guidance for guiding said substrate along said first transport path (T1) and a second guidance for guiding said substrate along said second transport path (T2).

9. The processing system (1) of any of the previous claims,
**characterized in that**
said first process chamber (4, 30) and/or said second process chamber (7, 40) include processing tools arranged in said respective process chamber laterally besides said first transport path (T1).

10. The processing system (1) of any of the previous claims,
**characterized in that**
combination of a first guidance section and second guidance section form a dual track module (43), and combination of a first guidance section, a second guidance section and a third guidance section form a triple track module (21, 33).

11. The processing system (1) of claim 10,
**characterized in that**
the guidance sections (22a, 22b, 22c) of the dual track modules and the triple track modules (21; 33), respectively, are configured to be driven independently in order to move two different substrates independently from each other along said first transport path (T1) or said second transport path (T2).

12. The processing system (1) of any of the previous claims,
**characterized in that**
the lock chamber (20) comprises a first triple track module (21), the first process chamber (30) comprises a second a triple track module (33), and the second process chamber (40) comprises a dual track module (43).

13. The processing system (1) of claim 10,
**characterized in that**
the dual track module (43) and/or the triple track module (21, 33) comprise two track sections (44a, 44b) and three track sections (22a, 22b, 22c; 34a, 34b, 34c), respectively, fixedly arranged relative to each other.

14. The processing system (1) of claim 13,
**characterized in that**
the track sections of the dual track module (43) and/or the triple track module (21, 33) are driven independently from each other to move a first substrate along the first transport path (T1) in a first direction and a second substrate along the second transport path (T2) in a second direction.

15. A method of operating a processing system (1) according to any of the previous claims, comprising the steps of:
a) transporting a first substrate from said lock chamber (3) into said first process chamber (4) along said first transport path (T1), and depositing a first layer on said first substrate;
b) laterally transferring said first substrate from said first transport path (T1) to said second transport path (T2); and
c) transporting said first substrate into said lock chamber (3) along said second transport path (T2),
**characterized in that**
said method comprises transporting a second substrate from said lock chamber (3) into said first process chamber (4) along said first transport path (T 1) during said method step c).

## Patentansprüche

1. Bearbeitungssystem (1) zum Bearbeiten eines Substrats, Folgendes aufweisend:
eine Anordnung von Kammern, darunter
zumindest eine erste Prozesskammer (4, 30) zum Bearbeiten des Substrats, eine zweite Prozesskammer (7, 40) zum Bearbeiten des Substrats und/oder eine Transferkammer (6);
zumindest eine Verschlusskammer (3, 20), die dazu ausgelegt ist, das Substrat in der Anordnung von Kammern einzuschließen und/oder ein Substrat aus der Anordnung von Kammern auszuschließen;
einen ersten Transportpfad (T1), um das Substrat durch die Anordnung von Kammern zu transportieren; und
einen zweiten Transportpfad (T2), um das Substrat durch die Anordnung von Kammern zu transportieren, wobei
der zweite Transportpfad (T2) in Bezug auf den ersten Transportpfad (T1) seitlich versetzt ist, wobei
zumindestens eine der ersten Prozesskammer (4, 30), der zweiten Prozesskammer (7, 40) und der Transferkammer (6), eine Einrichtung zum Transferieren des Substrats vom ersten Transportpfad (T1) zum zweiten Transportpfad (T2) und/oder vom zweiten Transportpfad (T2) zum ersten Transportpfad (T1) aufweist, wobei
die Einrichtung zum Transferieren des Substrats eine Kombination aus zumindest einem ersten Führungsabschnitt und einem zweiten Führungsabschnitt hat, wobei der erste Führungsabschnitt parallel zum zweiten Führungsabschnitt in einem Abstand angeordnet ist, der dem Abstand zwischen dem ersten Transportpfad und dem zweiten Transportpfad entspricht, und wobei
die Einrichtung zum Transferieren des Substrats eine Transfervorrichtung zur seitlichen Verschiebung der Kombination aufweist, um das Substrat vom ersten Transportpfad (T1) zum zweiten Transportpfad (T2) und umgekehrt zu bewegen.

2. Bearbeitungssystem (1) nach Anspruch 1, **dadurch gekennzeichnet, dass** die Einrichtung zum Transferieren des Substrats einen dritten Führungsabschnitt hat, der parallel zum ersten Führungsabschnitt und zweiten Führungsabschnitt angeordnet ist.

3. Bearbeitungssystem (1) nach Anspruch 1 oder 2,
**dadurch gekennzeichnet, dass**
die Einrichtung zum Transferieren des Substrats eine Transfervorrichtung zur seitlichen Verschiebung der Kombination hat, um das Substrat vom ersten Transportpfad (T1) zum zweiten Transportpfad (T2) und umgekehrt zu bewegen.

4. Bearbeitungssystem (1) nach einem der vorhergehenden Ansprüche,
**dadurch gekennzeichnet, dass**
der erste Führungsabschnitt, der zweite Führungsabschnitt und der dritte Führungsabschnitt in Bezug aufeinander in einem Abstand angeordnet sind, der dem Abstand zwischen dem ersten Transportpfad (T1) und dem zweiten Transportpfad (T2) entspricht.

5. Bearbeitungssystem (1) nach einem der vorhergehenden Ansprüche,
**dadurch gekennzeichnet, dass**
die erste Prozesskammer (4, 30), die zweite Prozesskammer (7, 40) und/oder die Transferkammer (6) in Reihe verbunden sind.

6. Bearbeitungssystem (1) nach einem der vorhergehenden Ansprüche,
**dadurch gekennzeichnet, dass**
das Bearbeitungssystem (1) ein Transportsystem aufweist, um ein Substrat entlang des ersten Transportpfads (T1) und entlang des zweiten Transportpfads (T2) zu transportieren.

7. Bearbeitungssystem (1) nach Anspruch 6,
**dadurch gekennzeichnet, dass**
das Transportsystem zumindest eine Führung hat, um das Substrat entlang des ersten Transportpfads (T1) und/oder entlang des zweiten Transportpfads (T2) zu führen.

8. Bearbeitungssystem (1) nach Anspruch 7,
**dadurch gekennzeichnet, dass**
das Transportsystem eine erste Führung, um das Substrat entlang des ersten Transportpfads (T1) zu führen, und eine zweite Führung hat, um das Substrat entlang des zweiten Transportpfads (T2) zu führen.

9. Bearbeitungssystem (1) nach einem der vorhergehenden Ansprüche,
**dadurch gekennzeichnet, dass**
die erste Prozesskammer (4, 30) und/oder die zweite Prozesskammer (7, 40) Bearbeitungswerkzeuge enthalten bzw. enthält, die in der jeweiligen Prozesskammer seitlich neben dem ersten Transportpfad (T1) angeordnet sind.

10. Bearbeitungssystem (1) nach einem der vorhergehenden Ansprüche,
**dadurch gekennzeichnet, dass**
eine Kombination aus einem ersten Führungsabschnitt und zweiten Führungsabschnitt ein Doppelspurmodul (43) bildet, und eine Kombination aus einem ersten Führungsabschnitt, einem zweiten Führungsabschnitt und einem dritten Führungsabschnitt ein Dreifachspurmodul (21, 33) bildet.

11. Bearbeitungssystem (1) nach Anspruch 10,
**dadurch gekennzeichnet, dass**
die Führungsabschnitte (22a, 22b, 22c) der Doppelspurmodule bzw. der Dreifachspurmodule (21; 33) dazu ausgelegt sind, unabhängig angetrieben zu werden, um zwei verschiedene Substrate unabhängig voneinander entlang des ersten Transportpfads (T1) oder des zweiten Transportpfads (T2) zu bewegen.

12. Bearbeitungssystem (1) nach einem der vorhergehenden Ansprüche,
**dadurch gekennzeichnet, dass**
die Verschlusskammer (20) ein erstes Dreifachspurmodul (21) aufweist, die erste Prozesskammer (4, 30) ein zweites Dreifachspurmodul (33) aufweist, und die zweite Prozesskammer (40) ein Doppelspurmodul (43) aufweist.

13. Bearbeitungssystem (1) nach Anspruch 10,
**dadurch gekennzeichnet, dass**
das Doppelspurmodul (43) und/oder das Dreifachspurmodul (21, 33) zwei Spurabschnitte (44a, 44b) bzw. drei Spurabschnitte (22a, 22b, 22c; 34a, 34b, 34c) aufweisen bzw. aufweist, die in Bezug aufeinander fest angeordnet sind.

14. Bearbeitungssystem (1) nach Anspruch 13, **dadurch gekennzeichnet, dass**
die Spurabschnitte des Doppelspurmoduls (43) und/oder des Dreifachspurmoduls (21, 33) unabhängig voneinander angetrieben werden, um ein erstes Substrat entlang des ersten Transportpfads (T1) in einer ersten Richtung und ein zweites Substrat entlang des zweiten Transportpfads (T2) in einer zweiten Richtung zu bewegen.

15. Verfahren zum Betreiben eines Bearbeitungssystems (1) nach einem der vorhergehenden Ansprüche, die folgenden Schritte umfassend:
a) Transportieren eines ersten Substrats aus der Verschlusskammer (3) entlang des ersten Transportpfads (T1) in die erste Prozesskammer (4), und Abscheiden einer ersten Schicht auf dem ersten Substrat;
b) seitliches Transferieren des ersten Substrats vom ersten Transportpfad (T1) zum zweiten Transportpfad (T2); und
c) Transportieren des ersten Substrats entlang des zweiten Transportpfads (T2) in die Verschlusskammer (3),
**dadurch gekennzeichnet, dass**
das Verfahren umfasst, während des Verfahrensschritts c) ein zweites Substrat aus der Verschlusskammer (3) entlang des ersten Transportpfads (T1) in die erste Prozesskammer (4) zu transportieren.

## Revendications

1. Système de traitement (1) destiné à traiter un substrat, comprenant :
un agencement de chambres incluant
au moins une première chambre de traitement (4, 30) destinée à traiter ledit substrat, une deuxième chambre de traitement (7, 40) destinée à traiter ledit substrat, et/ou une chambre de transfert (6) ;
au moins une chambre de verrouillage (3, 20) configurée pour verrouiller ledit substrat dans ledit agencement de chambres et/ou verrouiller un substrat hors dudit agencement de chambres ;
un premier chemin de transport (T1) destiné à transporter ledit substrat à travers ledit agencement de chambres ; et
un deuxième chemin de transport (T2) destiné à transporter ledit substrat à travers ledit agencement de chambres, sachant que
ledit deuxième chemin de transport (T2) est latéralement décalé par rapport audit premier chemin de transport (T1), sachant que
au moins une de ladite première chambre de traitement (4, 30), de ladite deuxième chambre de traitement (7, 40) et de ladite chambre de transfert (6) comprend des moyens destinés à transférer ledit substrat dudit premier chemin de transport (T1) audit deuxième chemin de transport (T2) et/ou dudit deuxième chemin de transport (T2) audit premier chemin de transport (T1), sachant que lesdits moyens destinés à transférer ledit substrat incluent une combinaison d'au moins une première section de guidage et une deuxième section de guidage,
sachant que ladite première section de guidage est agencée parallèlement à ladite deuxième section de guidage à une distance correspondant à la distance entre le premier chemin de transport et le deuxième chemin de transport, et sachant que lesdits moyens destinés à transférer ledit substrat comprennent un dispositif de transfert destiné à déplacer latéralement la combinaison afin de mouvoir le substrat du premier chemin de transport (T1) au deuxième chemin de transport (T2) et inversement.

2. Le système de traitement (1) de la revendication 1,
**caractérisé en ce que**
lesdits moyens destinés à transférer ledit substrat incluent une troisième section de guidage agencée parallèlement à ladite première section de guidage et à ladite deuxième section de guidage.

3. Le système de traitement (1) de la revendication 1 ou 2,
**caractérisé en ce que**
lesdits moyens destinés à transférer ledit substrat incluent un dispositif de transfert destiné à déplacer latéralement ladite combinaison afin de mouvoir un substrat dudit premier chemin de transport (T1) audit deuxième chemin de transport (T2) et inversement.

4. Le système de traitement (1) de l'une quelconque des revendications précédentes,
**caractérisé en ce que**
ladite première section de guidage, ladite deuxième section de guidage et ladite troisième section de guidage sont agencées les unes par rapport aux autres à une distance correspondant à la distance entre ledit premier chemin de transport (T1) et ledit deuxième chemin de transport (T2).

5. Le système de traitement (1) de l'une quelconque des revendications précédentes,
**caractérisé en ce que**
ladite première chambre de traitement (4, 30), ladite deuxième chambre de traitement (7, 40), et/ou ladite chambre de transfert (6) sont couplées en ligne.

6. Le système de traitement (1) de l'une quelconque des revendications précédentes,
**caractérisé en ce que**
ledit système de traitement (1) comprend un système de transport destiné à transporter un substrat le long dudit premier chemin de transport (T1) et le long dudit deuxième chemin de transport (T2).

7. Le système de traitement (1) de la revendication 6,
**caractérisé en ce que**
ledit système de transport comprend au moins un guidage destiné à guider un substrat le long dudit premier chemin de transport (T1) et/ou le long dudit deuxième chemin de transport (T2).

8. Le système de traitement (1) de la revendication 7,
**caractérisé en ce que**
ledit système de transport comprend un premier guidage destiné à guider ledit substrat le long dudit premier chemin de transport (T1) et un deuxième guidage destiné à guider ledit substrat le long dudit deuxième chemin de transport (T2).

9. Le système de traitement (1) de l'une quelconque des revendications précédentes,
**caractérisé en ce que**
ladite première chambre de traitement (4, 30) et/ou ladite deuxième chambre de traitement (7, 40) incluent des outils de traitement agencés dans ladite chambre de traitement respective latéralement à côté dudit premier chemin de transport (T1).

10. Le système de traitement (1) de l'une quelconque des revendications précédentes,
**caractérisé en ce que**
une combinaison d'une première section de guidage et d'une deuxième section de guidage forme un module de piste dual (43), et une combinaison d'une première section de guidage, d'une deuxième section de guidage et d'une troisième section de guidage forme un module de piste triple (21, 33).

11. Le système de traitement (1) de la revendication 10,
**caractérisé en ce que**
les sections de guidage (22a, 22b, 22c) des modules de piste duaux et des modules de piste triples (21 ; 33), respectivement, sont configurées pour être entraînées indépendamment afin de mouvoir deux substrats différents indépendamment l'un de l'autre le long dudit premier chemin de transport (T1) ou dudit deuxième chemin de transport (T2).

12. Le système de traitement (1) de l'une quelconque des revendications précédentes,
**caractérisé en ce que**
la chambre de verrouillage (20) comprend un premier module de piste triple (21), la première chambre de traitement (30) comprend un deuxième module de piste triple (33), et la deuxième chambre de traitement (40) comprend un module de piste dual (43).

13. Le système de traitement (1) de la revendication 10,
**caractérisé en ce que**
le module de piste dual (43) et/ou le module de piste triple (21, 33) comprennent deux sections de piste (44a, 44b) et trois sections de piste (22a, 22b, 22c ; 34a, 34b, 34c), respectivement, agencées de manière fixe les unes par rapport aux autres.

14. Le système de traitement (1) de la revendication 13,
**caractérisé en ce que**
les sections de piste du module de piste dual (43) et/ou du module de piste triple (21, 33) sont entraînées indépendamment l'une de l'autre pour mouvoir un premier substrat le long du premier chemin de transport (T1) dans une première direction et un deuxième substrat le long du deuxième chemin de transport (T2) dans une deuxième direction.

15. Procédé de fonctionnement d'un système de traitement (1) selon l'une quelconque des revendications précédentes, comprenant les étapes de :
a) transport d'un premier substrat de ladite chambre de verrouillage (3) à ladite première chambre de traitement (4) le long dudit premier chemin de transport (T1), et le dépôt d'une première couche sur ledit premier substrat ;
b) le transfert latéral dudit premier substrat dudit premier chemin de transport (T1) audit deuxième chemin de transport (T2) ; et
c) le transport dudit premier substrat à ladite chambre de verrouillage (3) le long dudit deuxième chemin de transport (T2),
**caractérisé en ce que**
ledit procédé comprend le transport d'un deuxième substrat de ladite chambre de verrouillage (3) à ladite première chambre de traitement (4) le long dudit premier chemin de transport (T1) pendant ladite étape de procédé c).
